# EUROPEAN PATENT APPLICATION

(11) **EP 2 615 889 A1**
(43) Date of publication of application: **17.07.2013**
(21) Application number: 11823665.2
(22) Date of filing: 09.09.2011
(51) Int. Cl.: H05H 1/46, C23C 16/509, H01L 21/205, H01L 21/3065

(54) **PLASMA PROCESSING APPARATUS**

(30) Priority: 10.09.2010 JP 2010203739
(71) Applicant: EMD Corporation, Shiga 520-2323 (JP)
(72) Inventor: SETSUHARA, Yuichi, Suita-shi Osaka 565-0871 (JP); EBE, Akinori, Shiga 5202323 (JP)
(74) Representative: Hehl, Ulrich
(86) International application number: PCT/JP2011/070581
(87) International publication number: WO 2012/033191

(57) **Abstract**

The present invention provides a plasma processing device which can generate plasma with a higher density than that in an external antenna type, and can prevent the impurities from being mixed into an object to be processed and can prevent particles from being generated, which are problems that occur in an internal antenna type. The plasma processing device according to the present invention has: a metallic vacuum chamber 11; an antenna-placing section 14 in which a radio-frequency antenna 18 is placed inside a through-hole (hollow space) provided in an upper wall 112 of the vacuum chamber 11; and a dielectric separating plate 15 covering the entire inner surface 1121 of the upper wall 112. In this plasma processing device, the entire inner surface 1121 side of the upper wall 112 is covered with the separating plate 15 so that surfaces in different level otherwise formed when a smaller separating plate is used is not formed between the inner surface 1121 and the separating plate 15. Therefore, the generation of particles caused by the formation of adhered materials on the surfaces in different level is prevented.

## Description

### TECHNICAL FIELD

The present invention relates to an inductively coupled plasma processing device which can be used for various surface processings of a base body and other purposes.

### BACKGROUND ART

Plasma processing devices have been used for a film formation process in which a thin-film is formed on a base body, and for an etching process on the surface of a base body. Such plasma processing devices include: a capacitively-coupled plasma processing device in which plasma is produced by the electric field generated by applying a radio-frequency voltage between electrodes; and inductively-coupled plasma processing devices in which plasma is produced by the induction electromagnetic field generated by feeding a radio-frequency current to a radio-frequency antenna (coil). Inductively-coupled plasma processing devices are advantageous in that they can produce plasma which is dense, yet has a low electron temperature and a low ion energy. Such plasma has a high film formation rate and does little damages to the object to be processed.

In inductively coupled plasma processing devices, a plasma production gas, such as hydrogen gas, is introduced into a vacuum chamber, after which an induction electromagnetic field is induced to decompose the plasma production gas and thereby produce plasma. Subsequently, another kind of gas, which serves as a film-forming material gas or an etching gas, is introduced into the vacuum chamber, where the molecules of the film-forming material gas are decomposed by the plasma and deposited on a base body, or the molecules of the etching gas are decomposed into ions or radicals for the etching process.

Conventional inductively-coupled plasma processing devices mainly used an external antenna system. In the external antenna system, a radio-frequency antenna for forming an induction electromagnetic field is provided outside a vacuum chamber and the induction electromagnetic field is introduced into the inside of the vacuum chamber through a dielectric wall or window provided on a portion of the wall of the vacuum chamber (refer to Patent Document 1, for example). However, in recent years, the area of base bodies and thin films formed thereon have grown in size. Consequently, the size of vacuum chambers is increasing, and therefore thicker walls (or windows) are being used in the vacuum chambers to cope with the pressure difference between the outside and the inside of the vacuum chambers. This disadvantageously lowers the intensity of the induction electromagnetic field formed in the vacuum chamber, and decreases the density of the produced plasma.

Patent Document 2 discloses an inductively-coupled plasma processing device using an internal antenna system in which a radio-frequency antenna is provided inside a vacuum chamber. With this plasma processing device, the density of the plasma can be easily increased irrespective of the thickness of the dielectric walls (or windows). Hence, this device is suitable for large-size base bodies and large-size thin films.

### BACKGROUND ART DOCUMENT

### PATENT DOCUMENT

[Patent Document 1] JP-A 8-227878 ([0010] and Fig. 5)
[Patent Document 2] JP-A 2001-035697 ([0050]-[0051] and Fig. 11)

### DISCLOSURE OF THE INVENTION

### PROBLEM TO BE SOLVED BY THE INVENTION

In an internal antenna system inductively-coupled plasma processing device in which the surface of the antenna is not covered with a dielectric material or other materials, the radio-frequency antenna and the plasma are capacitatively coupled and therefore electrons flow into the antenna. As a consequence, a direct-current self-bias is generated in the antenna. The direct-current self-bias generated in the antenna accelerates ions in the plasma, which fly toward the radio-frequency antenna, and the surface of the antenna is sputtered. This shortens the life of the radio-frequency antenna, and the sputtered materials of the radio-frequency antenna are mixed as impurities into the object to be processed.

When an internal antenna system is used, the material of the thin film or a by-product resulting from the etching process adheres to the surface of the radio-frequency antenna. The adhered material may fall and form particulate foreign matters (particles) on the surface of the base body.

The problem to be solved by the present invention is to provide a plasma processing device capable of generating plasma with a density higher than that in a device of an external antenna type, and of preventing impurities from being mixed into the object to be processed and forming particles, which are problems that occur in a device of an internal antenna type.

### MEANS FOR SOLVING THE PROBLEM

To solve the aforementioned problem, the present invention provides a plasma processing device, including:
a) a closed chamber for performing a plasma processing inside thereof, the closed chamber having a wall which is surrounded by a substantially-orthogonal edge line;
b) an antenna-placing section provided between an inner surface and an outer surface of the wall, the antenna-placing section being a hollow space with an opening on a side of the inner surface;
c) a radio-frequency antenna placed in the antenna-placing section; and
d) a dielectric separating plate covering an entire portion of the inner surface of the wall that is surrounded by the substantially-orthogonal edge line.

The "substantially-orthogonal edge line" is the line at the intersection of the above-mentioned inner surface of the wall and the inner surface of the surrounding wall, with an inner angle of between 70 and 120 degrees formed by the two surfaces.

In the plasma processing device according to the present invention, an antenna-placing section is provided between the inner and outer surfaces of the wall of the closed chamber, and a radio-frequency antenna is placed in the antenna-placing section. The induction electromagnetic field generated in the closed chamber is stronger in this configuration than in the case of the external antenna type.

The radio-frequency antenna and the inside of the closed chamber are separated by a dielectric separating plate. This prevents the radio-frequency antenna from being sputtered. This also prevents a film-forming material or a by-product resulting from the etching process from adhering to the radio-frequency antenna to form particles. Additionally, by covering the entire inner surface of the wall in which the antenna-placing section is provided with a plate, surfaces in different level are prevented from being formed between the wall surface and the separating plate. In general, a film-forming material and a by-product tend to adhere to irregular portions, such as surfaces in different level, in a closed chamber, causing particles to be formed. In contrast, in the present invention, there are no unnecessary surfaces in different level in the closed chamber, which eliminates the cause of the formation of particles.

The antenna-placing section may preferably be in vacuum or be filled with a dielectric material. This can prevent unwanted electric charges from occurring in the antenna-placing section. In the case where the antenna-placing section is filled with a dielectric material, it is preferable to minimize unfilled space in the antenna-placing section. However, a small amount of remaining unfilled space will not cause problem. The antenna-placing section filled with a dielectric material (but has a little unfilled space) may further be vacuumed.

A plurality of antenna-placing sections may be provided in a same wall. With this configuration, an induction electromagnetic field is generated in the closed chamber by a plurality of radio-frequency antennas. Therefore, a larger-area thin film can be manufactured and a larger-area base-body can be processed.

### EFFECTS OF THE INVENTION

In the plasma processing device according to the present invention, the radio-frequency antenna is placed in the antenna-placing section, which is provided between the inner and outer surfaces of a wall of the closed chamber. The internal space of the antenna-placing section and that of the closed chamber are separated by a dielectric separating plate. By virtue of this configuration, an induction electromagnetic field stronger than that in a conventional external antenna type is introduced to the inside of the closed chamber. In addition, this configuration prevents the radio-frequency antenna from being sputtered and prevents the film-forming material and by-products from attaching to the radio-frequency antenna and forming stray particles. Further, by covering the entire inner surface of the wall in which the antenna-placing section is provided with the separating plate, surfaces in different level otherwise formed when a smaller separating plate is used is prevented from being formed. This can prevent the film-forming material and by-products from attaching to the surfaces in different level and thereby generating particles.

### BRIEF DESCRIPTION OF THE DRAWINGS

Fig. 1 is a vertical sectional view showing a first embodiment of a plasma processing device according to the present invention.
Fig. 2 is a vertical sectional view of main components of a plasma processing device of a comparative example.
Fig. 3 is a vertical sectional view showing an example of a vacuum chamber used in the plasma processing device of the present embodiment.
Fig. 4 is a vertical sectional view showing a second embodiment of a plasma processing device according to the present invention.
Fig. 5 is a vertical sectional view of main components of a plasma processing device of a comparative example.
Fig. 6 is vertical sectional view of the main components showing a third embodiment of a plasma processing device according to the present invention.
Fig. 7 is a vertical sectional view of main components showing a modification example of the third embodiment.
Fig. 8A shows a relationship between an operation section of a radio-frequency antenna and a wall surface of a hollow space provided inside the wall of a vacuum chamber in a fourth embodiment of a plasma processing device according to the present invention, Fig. 8B shows a change of an induction electromagnetic field which is formed around the operation section when a distance x between the operation section and the wall surface of the hollow space is changed, and Fig. 8C is a graph showing relationship between the distance x and the intensity of the magnetic field.
Fig. 9 is a graph showing a change of electron density when radio-frequency power is changed in the case where x=20 mm or x=83 mm.
Figs. 10A through 10C are vertical sectional views of main components showing a modification example of the fourth embodiment.
Fig. 11 is a vertical sectional view of main components showing another modification example of the fourth embodiment.
Fig. 12 is a vertical sectional view of main components showing a modification example of the first embodiment.
Fig. 13 is a vertical sectional view of main components showing another modification example of the first embodiment.

### BEST MODES FOR CARRYING OUT THE INVENTION

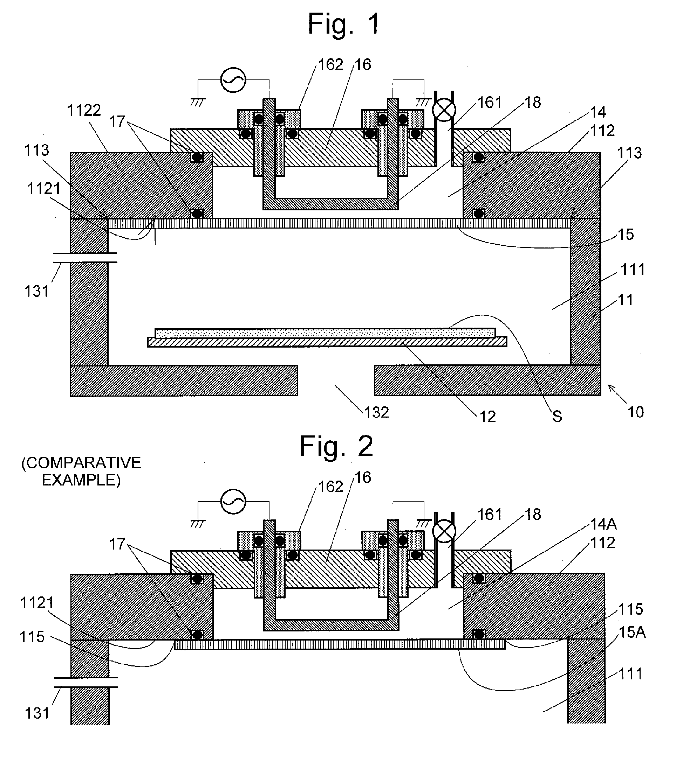

Embodiments of the plasma processing device according to the present invention are described with reference to Figs. 1 through 13.

### FIRST EMBODIMENT

First, a plasma processing device 10 of the first embodiment is described. As shown in Fig. 1A, the plasma processing device 10 includes: a metallic vacuum chamber 11; a base-body holder 12 placed in an internal space 111 of the vacuum chamber; a gas introduction port 131 provided in a side wall of the vacuum chamber 11; a gas discharge port 132 provided in a lower wall of the vacuum chamber 11; an antenna-placing section 14 in which a radio-frequency antenna 18 is placed inside a through-hole (hollow space) provided in an upper wall 112 of the vacuum chamber 11; and a dielectric separating plate 15 covering the entire inner surface 1121 of the upper wall 112. In the present embodiment, the inner surface 1121 is a portion surrounded by a substantially-orthogonal edge line 113, and the upper wall 112 is a wall corresponding to the inner surface 1121. The dielectric material for the separating plate 15 may be oxide, nitride, carbide, fluoride, or other materials. Among these materials, it is preferable to use quartz, alumina, zirconia, yttria, silicon nitride, or silicon carbide.

The internal space of the antenna-placing section 14 is closed by the separating plate 15, a cover 16 and gas seals 17. The separating plate 15 closes an opening of the upper wall 112 on the inner surface 1121 side, and the cover 16 closes an opening on an outer surface 1122 side. The gas seals are provided between the inner surface 1121 and the separating plate 15, and between the outer surface 1122 and the cover 16. A vacuum sucking port 161 is provided in the cover 16. The air in the internal space is sucked through the vacuum sucking port 161 so that the inside of the antenna-placing section 14 becomes vacuum.

The radio-frequency antenna 18 used in the present embodiment is made by forming a linear conductor in a U-shape. This radio-frequency antenna is a coil of less than one turn. Such a radio-frequency antenna can keep the inductance low, which lowers the voltage applied to the radio-frequency antenna 18 when a radio-frequency power is supplied. Consequently, a base body to be processed is prevented from being damaged by plasma. The conductor of the antenna may be a pipe through which a cooling medium such as water circulates.

Both ends of the radio-frequency antenna 18 are attached to the cover 16 via a feedthrough 162. Therefore, the radio-frequency antenna 18 is easily attached to and detached from the plasma processing device with just an attachment and detachment of the cover 16. One end of the radio-frequency antenna 18 is connected to a radio-frequency power source and the other end is connected to a ground.

As an example of the operation of the plasma processing device 10 of the present embodiment, a process of depositing a film-forming material on a base body S which is held on the base-body holder 12 is described hereinafter. First, the base body S is placed onto the base-body holder 12. The air, steam and other contents in the internal space 111 are discharged through the gas discharge port 132 so that the internal space 111 is in a vacuum state. Simultaneously, the air, steam and other contents in the antenna-placing section 14 are discharged through the vacuum sucking port 161 so that the inside of antenna-placing section 14 is in a vacuum state. Subsequently, a plasma production gas and a thin-film material gas are introduced from the gas introduction port 131. Then, a radio-frequency electric current is supplied to the radio-frequency antenna 18 to form an induction electromagnetic field around the radio-frequency antenna 18. This induction electromagnetic field is introduced through the separating wall 15 into the internal space 111 and ionizes the plasma production gas, thereby producing plasma. The material gas, which has been introduced into the internal space 111 together with the plasma production gas, is decomposed by the resultant plasma, to be deposited on the base body S.

In the case of an etching process, the operation of the plasma processing device 10 is the same as that in the above-mentioned film-forming process, except that a plasma production gas for etching, rather than a film-forming material gas, is introduced from the gas introduction port 131.

One of the characteristic features of the plasma processing device 10 of the present embodiment is that the entire inner surface 1121 of the upper wall 112 in which the antenna-placing section 14 is provided is covered with a separating plate 15, which prevents surfaces in different level from being formed between the inner surface 1121 and the separating plate 15. As shown in the comparative example in Fig. 2, for example, in the case where a separating plate 15A is provided only at the portion immediately below an antenna-placing section 14A, surfaces 115 in different level are formed between the separating plate 15A and the inner surface 1121. A film-forming material and a by-product resulting from the etching process attach easily to the portion around the surface 115 in different level. Such adhered materials may fall onto the surface of the base body S, which causes particles to be formed. In contrast, in the plasma processing device 10 of the present embodiment, the separating plate 15 is provided so as to cover the entire inner surface 1121, which prevents the formation of surfaces in different level, as in the comparative example of Fig. 2. Therefore, undesirable materials hardly adhere thereon.

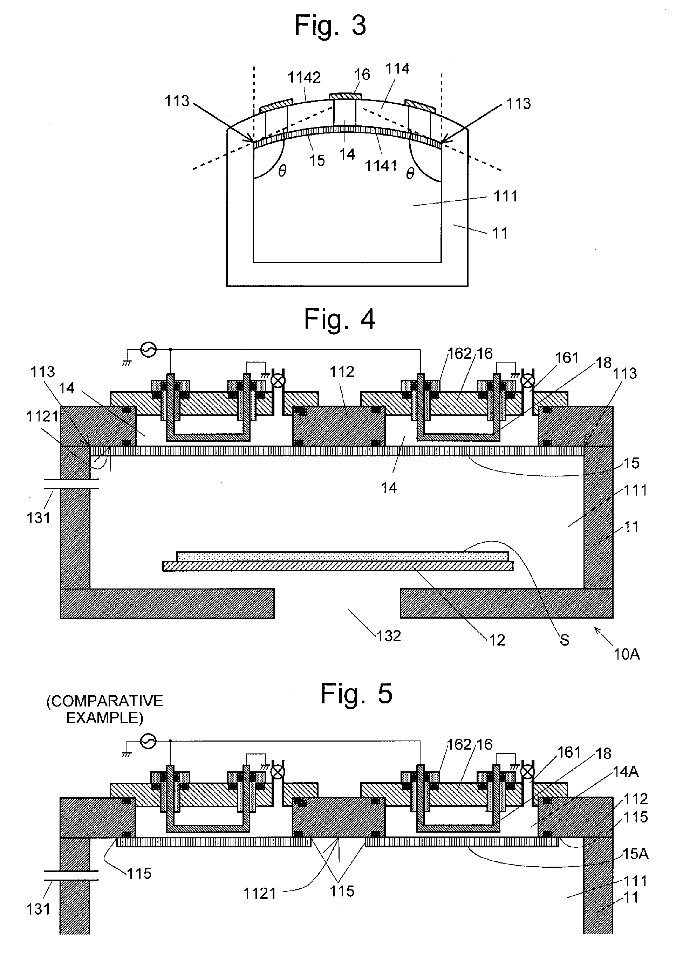

Fig. 3 shows a modification example of the first embodiment. Fig. 3 shows an example in which the vacuum chamber 11 has a curved upper wall 114 which is surrounded by the substantially-orthogonal edge line 113, and a plurality of antenna-placing sections 14 are provided between the inner surface 1141 and the outer surface 1142 of the curved upper wall 114. Theoretically, an inner angle θ formed by the substantially-orthogonal edge line 113 can be any angle. However, practically, it may be between 70 and 120 degrees (θ=90° in the above-described first embodiment). The separating plate 15 is provided so as to cover the entire inner surface 1141 as shown in the first embodiment. In the case where the portion onto which the separating plate 15 is placed is curved as shown in Fig. 3A, it is preferable that a shape of the separating plate 15 is curved accordingly.

### SECOND EMBODIMENT

A plasma processing device 10A of the second embodiment is described hereinafter with reference to Fig. 4. In the plasma processing device 10A of the present embodiment, a plurality of antenna-placing sections 14 are provided in the upper wall 112. A radio-frequency antenna 18 is provided in each of the antenna-placing sections 14. The radio-frequency antennas 18 are connected to a radio-frequency power source in parallel. Each of the antenna-placing sections 14 has a cover 16, a vacuum sucking port 161, a feedthrough 162, and gas seals 17. However, only one separating plate 15 is provided for all the antenna-placing sections 14 to cover the entire inner surface 1121. The definitions of the upper wall 112 and its inner surface 1121, which are described in the present embodiment and the following embodiments, are the same as that in the first embodiment.

The operation of the plasma processing device 10A of the present embodiment is the same as that of the plasma processing device 10 of the first embodiment. In the plasma processing device 10A of the present embodiment, an induction electromagnetic field is produced by a plurality of radio-frequency antennas 18. This enables a larger-area thin-film to be formed and a larger-area base-body to be processed than before.

If the separating plates 15A are provided only immediately below the antenna-placing sections 14A as in a comparative example shown in Fig. 5, surface 115 in different level are formed between the separating plate 15A and the inner surface 1121 for each of the antenna-placing sections 14A. In contrast, such surfaces in different level are not formed in the plasma processing device 10A of the present embodiment. Therefore, particles are hardly formed.

### THIRD EMBODIMDNT

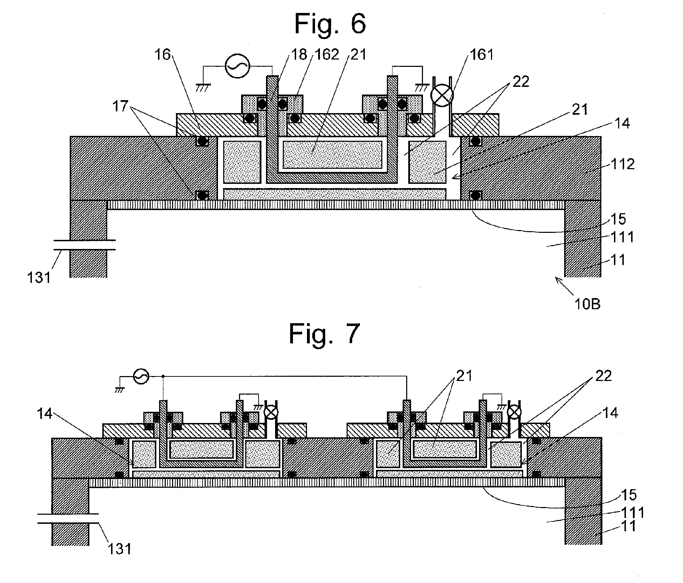

The plasma processing device 10B of the third embodiment is described hereinafter with reference to Fig. 6. In the plasma processing device 10B of the present embodiment, in addition to the configuration of the plasma processing device 10 of the first embodiment, the antenna-placing section 14 is filled with a dielectric material 21. The dielectric material 21 may be such materials as polytetrafluoroethylene (PTFE), polyether ether ketone (PEEK) or other kinds of resin, alumina, or silica or other kinds of ceramics. Preferably, the space of the antenna-placing section 14 is thoroughly filled with the dielectric material 21. However, when actually manufactured, it is likely that an unfilled space 22 remains between the metallic walls of the vacuum chamber and the dielectric material 21, and between the radio-frequency antenna 18 and the dielectric material 21. In light of this, in the present embodiment, a vacuum sucking port 161 is provided in the cover 16 as in the plasma processing device 10 of the first embodiment. By sucking the air from the vacuum sucking port 161, the inside of the antenna-placing section 14 becomes a vacuum. This can prevent unwanted electric discharges from occurring in the unfilled space 22. It should be noted that the unfilled space 22 is illustrated in exaggeration for convenience' sake of explanation.

In the example of Fig. 6, only one antenna-placing section 14 is provided. However, as shown in Fig. 7, a plurality of antenna-placing sections 14 may be provided as in the second embodiment and each of the antenna-placing sections 14 may be filled with the dielectric material 21.

### FOURTH EMBODIMENT

In order to efficiently produce plasma in the plasma processing device according to the present invention, it is important that efficient contribution to plasma production is made by the induction electromagnetic field produced by supplying a radio-frequency current to the radio-frequency antenna 18. The present embodiment shows the structure of an antenna-placing section (hollow space) 14 which enables efficient plasma production.

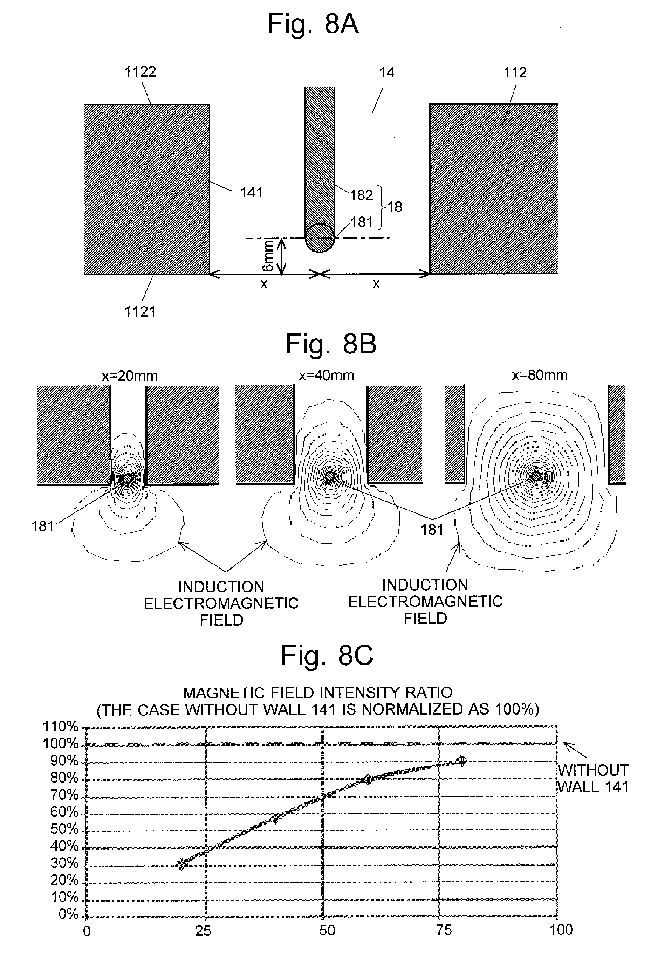

In the U-shaped conductor of the radio-frequency antenna 18 placed in the antenna-placing section 14, a portion which contributes the most to the plasma production and the surface processing of the base body S is the conductor of the section which connects them, not the conductor of the two parallel linear portions 182. Hereinafter, the conductor of the portion which contributes the most to the plasma production and the surface processing of the base body S is referred to as an "operation section." In the present embodiment, the distance x between the operation section 181 and the wall surface 141 of the hollow space 14 is first considered (Fig. 8A).

Fig. 8B shows the result of a simulation of the induction electromagnetic field generated around the operation section 181 with different values of x. The frequency of the radio-frequency power supplied to the antenna conductor of the operation section 181 was set at 13.56 MHz, the electric current flowing through the antenna conductor was set at 10 Arms, the diameter of the antenna conductor was set at 6.35, and the electrical conductivity of the antenna conductor was set at 1000000 S/m.

In the case of x=20 mm, as shown in Fig. 8B, a large amount of the induction electromagnetic field was blocked by the wall surface 141, thereby decreasing the amount of induction electromagnetic field discharged into the internal space of the vacuum chamber 11. In contrast, in the case of x=40 mm, more induction electromagnetic field was discharged into the internal space than in the case of x=20 mm. In the case where the distance x was as large as 80 m, the induction electromagnetic field was largely unimpeded by the wall surface 141, and was efficiently discharged to the internal space of the vacuum chamber 11.

Fig. 8C shows the result of a simulation for comparing the amounts of the induction electromagnetic field discharged into the internal space with different values of x. In this simulation, the amount of the induction electromagnetic field discharged into the internal space of the vacuum chamber 11 when x is at infinity is set at the reference value (100%). In comparison with the case of x at infinity, only approximately 30% of the induction electromagnetic field was discharged into the internal space when x=20 mm. However, when the distance x was as large as 80 mm, nearly 90% of the induction electromagnetic field was discharged into the internal space of the vacuum chamber 11. In the present embodiment, the antenna-placing section 14 is provided so as to satisfy x≥30 mm in order that, with respect to the case of x at infinity, 50% or more of the induction electromagnetic field is discharged into the internal space.

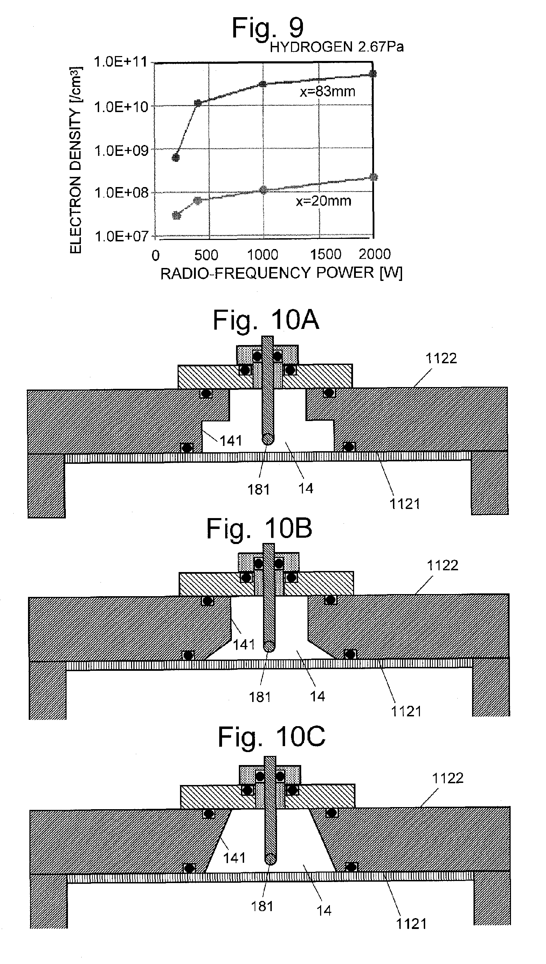

Fig. 9 shows a result of a comparison of a change of the plasma density with respect to different radio-frequency powers when the distance x was actually set at 20 mm and 83 mm in the antenna-placing section 14. In the experiment result shown in Fig. 9, the plasma density differed significantly between the case of x=20 mm and the case of x=83 mm. The plasma density in the case of x=83 mm was approximately 200 times larger than that in the case of x=20 mm. This result shows that quadrupling the distance x increases the electron density of the plasma with more efficiency than quadrupling the radio-frequency power supplied to the radio-frequency antenna 18. This enables a production of high-density plasma at low cost.

Figs. 10A through 10C show modification examples of the plasma processing device of the present embodiment. In the present modification examples, a shape of the antenna-placing section 14 is of interest. As shown in Figs. 10A through 10C, the antenna-placing section 14 is wider at the inner surface 1121 side than at the outer surface 1122 side of the vacuum chamber 11. Also, these configurations can facilitate the discharge of the induction electromagnetic field formed around the operation section 181 of the radio-frequency antenna 18 into the internal space of the vacuum chamber 11. Although not shown, the inside of the antenna-placing section 14 may preferably be filled with a dielectric material.

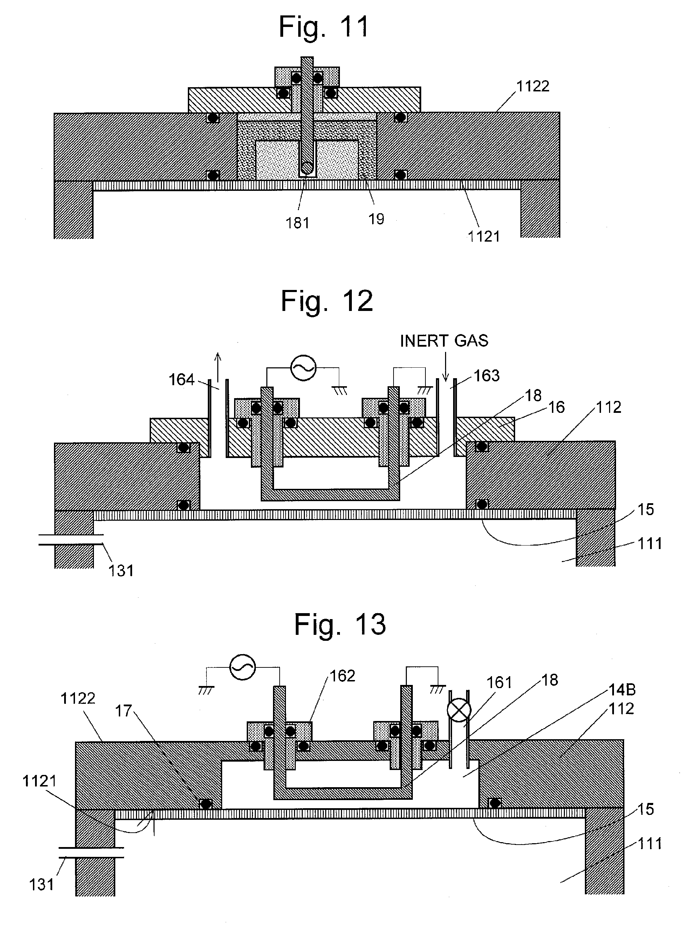

The modification example shown in Fig. 11 may be used. In this modification example, a magnetic member 19 made of ferrite or other materials is provided along the operation section 181 of the radio-frequency antenna 18 in the inside of the antenna-placing section 14. The magnetic member 19 has an opening on the inner surface 1121 side of the vacuum chamber 11. By means of the magnetic member 19, the induction electromagnetic field discharged to the outer surface 1122 side of the vacuum chamber 11 is made to pass through the inside of the magnetic member 19 and to be discharged into the internal space of the vacuum chamber 11. Therefore, the induction electromagnetic field discharged from the operation section 181 can efficiently contribute to the production of plasma.

### FIFTH EMBODIEMNT

The present invention is not limited to the above-described the first through the fourth embodiments. For example, in the first through the fourth embodiments, the vacuum sucking port 161 for sucking the inside of the antenna-placing section 14 to a vacuum is provided in the cover 16. In place of this, as shown in Fig. 12, an inert gas introduction port 163 and an inert gas discharge port 164 may be provided in the cover 16. In the example of Fig. 12, an inert gas such as argon or nitrogen is introduced from the inert gas introduction port 163 so as to discharge the air and steam in the antenna-placing section 14 through the inert gas discharge port 164. Consequently, the air and steam are replaced with the inert gas, and the inside of the antenna-placing section 14 is filled with the inert gas. This can prevent a production of unwanted electric discharges in the antenna-placing unit 14.

In the first through the fourth embodiments, in the antenna-placing section 14, the cover 16 is provided on the outer surface 1122 side of the through-hole provided in the upper wall 112. As shown in Fig. 13, an antenna-placing section 14B may be formed by providing a hollow space having an opening only at the inner surface 1121 side of the upper wall 112. In this case, both ends of the radio-frequency antenna 18 are fixed to the portions of the upper wall 112 which are not penetrated.

**EXPLANATION OF NUMERALS**

| | |
|---|---|
| 10, 10A, 10B | Plasma Processing Device |
| 11 | Vacuum Chamber |
| 111 | Internal Space |
| 112, 114 | Upper Wall |
| 1121, 1141 | Inner Surface |
| 1122, 1142 | Outer Surface |
| 113 | Substantially-Orthogonal Edge Line |
| 12 | Base-Body Holder |
| 131 | Gas Introduction Port |
| 132 | Gas Discharge Port |
| 14, 14A, 14B | Antenna-Placing Section (Hollow Space) |
| 141 | Wall Surface of the Antenna-Placing Section (Hollow Space) |
| 15, 15A | Separating Plate |
| 115 | Surfaces in different level |
| 16 | Cover |
| 161 | Vacuum Sucking Port |
| 162 | Feedthrough |
| 163 | Inert Gas Introduction Port |
| 164 | Inert Gas Discharge Port |
| 17 | Gas Seal |
| 18 | Radio-Frequency Antenna |
| 181 | Operation Section |
| 182 | Linear Portion |
| 19 | Magnetic Member |
| 21 | Dielectric Material |
| 22 | Unfilled Space |
| S | Base Body |

## Claims

1. A plasma processing device, comprising:
a) a closed chamber for performing a plasma processing inside thereof, the closed chamber having a wall which is surrounded by a substantially-orthogonal edge line;
b) an antenna-placing section provided between an inner surface and an outer surface of the wall, the antenna-placing section being a hollow space with an opening on a side of the inner surface;
c) a radio-frequency antenna placed in the antenna-placing section; and
d) a dielectric separating plate covering an entire portion of the inner surface of the wall that is surrounded by the substantially-orthogonal edge line.

2. The plasma processing device according to claim 1, wherein the hollow space has an opening on a side of the outer surface and the outer-surface-side opening is closed by a cover.

3. The plasma processing device according to claim 2, wherein the radio-frequency antenna is attached to the cover.

4. The plasma processing device according to any one of claims 1 through 3, wherein the antenna-placing section is a closed space.

5. The plasma processing device according to claim 4, wherein the antenna-placing section is in a vacuum state.

6. The plasma processing device according to claim 4, wherein the antenna-placing section is filled with an inert gas.

7. The plasma processing device according to any one of claims 1 through 6, wherein the antenna-placing section is filled with a dielectric material.

8. The plasma processing device according to any one of claims 1 through 7, wherein a plurality of antenna-placing sections are provided in a same wall.

9. The plasma processing device according to any one of claims 1 through 8, wherein a distance between an operation section of the radio-frequency antenna and the wall of the hollow space is 30 mm or more in a direction perpendicular to an electric current flowing through the operation section.

10. The plasma processing device according to any one of claims 1 through 9, wherein the hollow space becomes wider from a side of the outer surface toward a side of the inner surface.

11. The plasma processing device according to any one of claims 1 through 10, wherein, in the antenna-placing section, an area surrounding the operation section of the radio-frequency antenna, other than the side of the inner surface, is covered with a magnetic member.

12. The plasma processing device according to claim 11, wherein a material of the magnetic member is ferrite.
